# EUROPEAN PATENT APPLICATION

(11) **EP 4 718 085 A1**
(43) Date of publication of application: **01.04.2026**
(21) Application number: 25184533.5
(22) Date of filing: 23.06.2025
(51) Int. Cl.: G01R 19/25, H02H 3/087, H02H 7/18, H02J 7/00, G01R 19/165

(54) **CURRENT DETECTION CIRCUIT AND CURRENT DETECTION METHOD**

(30) Priority: 25.09.2024 CN 202411345741; 25.09.2024 CN 202422354602 U
(71) Applicant: Eve Energy Co., Ltd., Huizhou, Guangdong 516006 (CN)
(72) Inventor: HU, Jun, Huizhou (CN); SHEN, Ruizhang, Huizhou (CN); XIONG, Chengsi, Huizhou (CN); WANG, Huabin, Huizhou (CN)
(74) Representative: Herrero & Asociados, S.L.

(57) **Abstract**

A current detection circuit (1) and a current detection method are provided. The current detection circuit (1) comprises a current conversion module (10), a logic processing module (20), and a high-side driver module (30). The current conversion module (10) is configured to convert an analog signal corresponding to the target current of a target battery cell into a target current digital quantity. The logic processing module (20) is connected to the current conversion module (10) and configured to output a target signal to the high-side driver module (30) based on a comparison detection result between a preset threshold value and the target current digital quantity. The high-side driver module (30) is connected to the logic processing module (20) and configured to determine whether to cut off an external power supply based on the target signal.

## Description

### TECHNICAL FIELD

The present disclosure relates to the field of current detection technologies, and in particular, to a current detection circuit and a current detection method.

### BACKGROUND

Cell current detection, diagnosis, and protection are basic demands of a battery management system (BMS), which can ensure the safety of the BMS and prevent thermal runaway. However, detection and diagnosis functions and a protection function are generally implemented by a combination of a plurality of different IC function circuits, for example, one is responsible for a collection diagnosis function, and the other is responsible for a protection execution function.

This manner has high costs and design difficulty, and high frequency of failure, resulting in poor reliability of cell current detection, diagnosis and protection.

With regard to the situation in related technologies that the reliability of the cell current detection, diagnosis, and protection is poor due to the fact that the cell current detection, diagnosis, and protection are realized by different IC functional circuits, no effective solution has been proposed at present.

### SUMMARY

According to a first aspect, the present disclosure provides a current detection circuit. The current detection circuit comprises a current conversion module, a logic processing module, and a high-side driver module. The current conversion module is configured to convert an analog signal corresponding to a target current of a target battery cell into a target current digital quantity. The logic processing module is connected to the current conversion module and configured to output a target signal to the high-side driver module based on a comparison detection result between a preset threshold value and the target current digital quantity. The high-side driver module is connected to the logic processing module and configured to determine whether to cut off an external power supply based on the target signal.

According to a second aspect, the present disclosure provides a current detection method. The method comprises: converting, by a current conversion module, an analog signal corresponding to a target current of a target battery cell into a target current digital quantity; outputting, by a logic processing module, a target signal to a high-side driver module based on a comparison detection result between a preset threshold and the target current digital quantity; and determining, by the high-side driver module, whether to cut off an external power supply based on the target signal.

The beneficial effects provided in the present disclosure are: the current conversion module is configured to convert an analog signal corresponding to a target current of a target battery cell into a target current digital quantity; the logic processing module is connected to the current conversion module and the high-side driver module, respectively, the logic processing module is configured to output a target signal to the high-side driver module based on a comparison detection result between a preset threshold value and the target current digital quantity; the high-side driver module is configured to determine whether to cut off an external power supply based on the target signal, thereby solving the problem in the related technologies that the reliability of cell current detection, diagnosis, and protection is poor due to the fact that the cell current detection, diagnosis, and protection are realized by different IC function circuits. In this solution, the current conversion module converts an analog signal corresponding to a current of a target battery cell into a target current digital quantity, then the logic processing module outputs a target signal to the high-side driver module based on a comparison detection result between a preset threshold value and the target current digital quantity, finally, the high-side driver module determines whether to cut off an external power supply based on the target signal. The current detection circuit realizes the cell current detection, diagnosis, and protection by an integration of the voltage conversion module, the logic processing module and the high-side driver module, thereby achieving the effect of improving the reliability of the cell current detection, diagnosis, and protection.

### BRIEF DESCRIPTION OF THE DRAWINGS

FIG. 1 is a first schematic diagram of a current detection circuit according to embodiments of the present disclosure;
FIG. 2 is a second schematic diagram of a current detection circuit according to the embodiments of the present disclosure;
FIG. 3 is a third schematic diagram of a current detection circuit according to the embodiments of the present disclosure;
FIG. 4 is a first schematic diagram of current conversion module according to the embodiments of the present disclosure;
FIG. 5 is a second schematic diagram of a current conversion module according to the embodiments of the present disclosure;
FIG. 6 is a third schematic diagram of a current detection circuit according to the embodiments of the present disclosure;
FIG. 7 is a schematic diagram of a logic processing module according to the embodiments of the present disclosure;
FIG. 8 is a fourth schematic diagram of a current detection circuit according to the embodiments of the present disclosure;
FIG. 9 is a flowchart of a current detection method according to the embodiments of the present disclosure;

Reference numerals: 1, current detection circuit; 10, current conversion module; 20, logic processing module; 30, high-side driver module; 100, analog-to-digital conversion module; 101, digital correction module; 1000, carrier suppression analog modulator; 1001, digital filter; 1002, first compensation module; 1010, digital corrector; 1011, digital signal processor; 1012, second compensation module; 200, electronic buffer; 201, comparator module; 2010, serial peripheral interface; 2011, register; 2012, comparator; 40, boost circuit.

### DETAILED DESCRIPTION

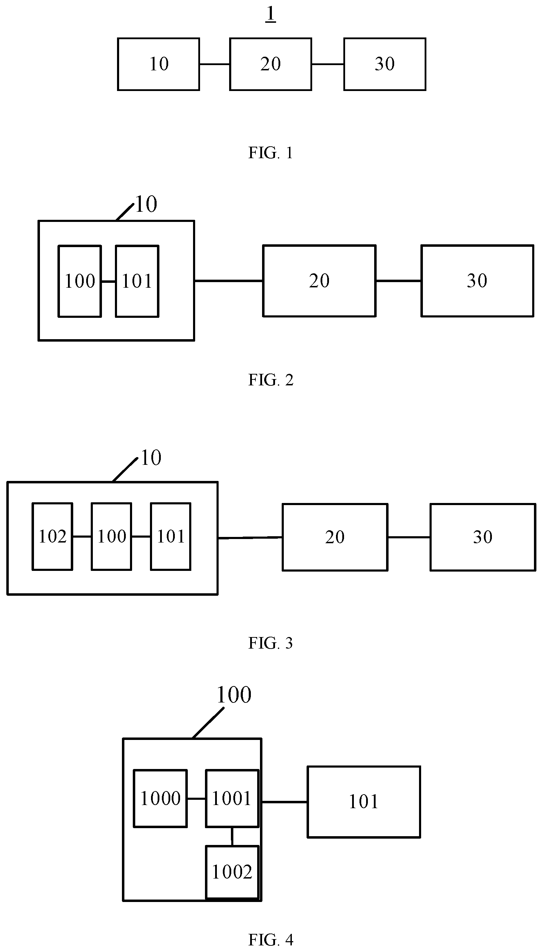

The present disclosure will be described below in conjunction with an implementation device. FIG. 1 is a first schematic diagram of a current detection circuit according to the embodiments of the present disclosure. As shown in FIG. 1, the current detection circuit 1 includes a current conversion module 10, a logic processing module 20 and a high-side driver module 30.

The current conversion module 10 is configured to convert an analog signal corresponding to a target current of a target battery cell into a target current digital quantity.

The logic processing module 20 is connected to the current conversion module 10 and the high-side driver module 30, respectively. The logic processing module 20 is configured to output a target signal to the high-side driver module 30 based on a comparison detection result between a preset threshold value and the target current digital quantity.

The high-side driver module 30 is configured to determine whether to cut off an external power supply based on the target signal.

The analog signal corresponding to the target current of the target battery cell is received through the current conversion module 10. It should be noted that, the current of the target battery cell can be collected by a current collection device, and then the collected current is input to a receiving pin PIN of the current conversion module 10. After receiving the analog signal corresponding to the target current of the target battery cell, the current conversion module 10 performs discrete quantization filtering on the analog signal to extract a digital signal, and then converts the digital signal obtained into an accurate current digital quantity, so as to obtain the target current digital quantity.

After obtaining the target current digital quantity, the current conversion module 10 can transmit the target current digital quantity to the logic processing module 20 through a serial peripheral interface (SPI interface). The logic processing module 20 outputs the target signal to the high-side driver module 30 based on the comparison detection result between the preset threshold value and the target current digital quantity, that is, the logic processing module 20 performs a threshold judgement, and triggers a response signal to the high-side driver module 30 according to a threshold determination result. The high-side driver module 30 determines, according to the target signal, whether to cut off the external power supply. For example, when the cell current value reaches a configured threshold, the high-side driver module 30 is triggered, by a CMD logic control signal, to perform a shutdown action, so as to cut off the external power supply of the battery for protection.

It should be noted that, the CMD logic control signal refers to a logic signal configured to control a switch state of a high-side driver. In an application of the high-side driver, these signals may be controlled through an SPI interface or other communication protocols.

It should be noted that the logic processing module 20 may be implemented by a digital comparator or a current detector.

In the present disclosure, the current conversion module 10 converts an analog signal corresponding to a current of a target battery cell into a target current digital quantity, then the logic processing module 20 outputs a target signal to the high-side driver module 30 based on a comparison detection result between a preset threshold value and the target current digital quantity, finally, the high-side driver module 30 determines whether to cut off an external power supply based on the target signal. The current detection circuit 1 realizes the cell current detection, diagnosis and protection by an integration of the current conversion module 10, the logic processing module 20 and the high-side driver module 30, thereby achieving the effect of improving the reliability of the cell current detection, diagnosis, and protection.

As shown in FIG. 2, in the current detection circuit 1 provided in an embodiment of the present disclosure, the current conversion module 10 comprises an analog-to-digital conversion module 100 and a digital correction module 101. The analog-to-digital conversion module 100 is connected to the digital correction module 101 and configured to convert the analog signal corresponding to the target current of the target battery cell into a digital signal corresponding to the target current. The digital correction module 101 is configured to process the digital signal corresponding to the target current to obtain the target current digital quantity.

In an embodiment, The analog-to-digital conversion module 100 is configured to modulate the analog signal corresponding to the target current to obtain a modulated signal, for example, perform discretization processing on the analog signal, and then filter the signal discretized to extract a digital signal, so as to obtain the digital signal corresponding to the target current. In order to improve the accuracy of the digital signal, the digital correction module 101 verifies and encodes the digital signal to obtain the accurate current digital quantity. For example, the digital quantity is verified and encoded by means of register mapping control and anon-volatile memory ( NVM) storage parameter configuration to obtain the accurate current digital quantity.

In an embodiment, the current conversion module 10 may be further provided with a diagnosis module (DIAG). The accuracy of the current value may be monitored and diagnosed by the DIAG. The DIAG may detect whether the current conversion module 10 operates normally, whether a situation that the current exceeds a threshold value, etc.

The current digital quantity corresponding to the battery cell may be accurately extracted by the analog-to-digital conversion module 100 and the digital correction module 101.

As shown in FIG. 3, in the current detection circuit 1 provided in an embodiment of the present disclosure, the current conversion module 10 further comprises an analog filter 102, which is connected to the analog-to-digital conversion module 100 and configured to perform filtering processing on an initial analog signal corresponding to the target current, to obtain the analog signal corresponding to the target current.

The analog filter 102 can effectively remove or reduce unwanted frequency components while preserving desired signals, thereby improving the accuracy of the analog signal corresponding to the target current obtained subsequently.

As shown in FIG. 4, in the current detection circuit 1 provided in an embodiment of the present disclosure, the analog-to-digital conversion module 100 comprises: a carrier suppression analog modulator 1000 and a digital filter 1001. The carrier suppression analog modulator 1000 is configured to modulate the analog signal corresponding to the target current to obtain a modulated signal. The digital filter 1001 is connected to the carrier suppression analog modulator 1000, and configured to perform filtering processing on the modulated signal to obtain the digital signal corresponding to the target current.

In an embodiment, after receiving a current value of the target battery cell, the carrier suppression analog modulator 1000 modulates the analog signal corresponding to the target current, for example, performs discretization processing on the analog signal corresponding to the target current to obtain the modulated signal. The digital filter 1001 performs filtering processing on the modulated signal to obtain a digital signal corresponding to the target current, that is, the digital filter 1001 filters the signal discretized through the discretization processing to obtain the digital signal corresponding to the target current.

As shown in FIG. 4, the current detection circuit 1 provided in an embodiment of the present disclosure, the analog-to-digital conversion module 100 further comprises a first compensation module 1002, which is connected to the digital filter 1001 and configured to perform compensation processing when the digital filter 1001 performs filtering processing on the modulated signal, so as to obtain the digital signal corresponding to the target current.

It should be noted that, the first compensation module 1002 may obtain compensation parameters through an SPI interface, so as to realize compensation for the signal. The compensation processing performed by the first compensation module 1002 can effectively improve the accuracy of the digital signal corresponding to the target current.

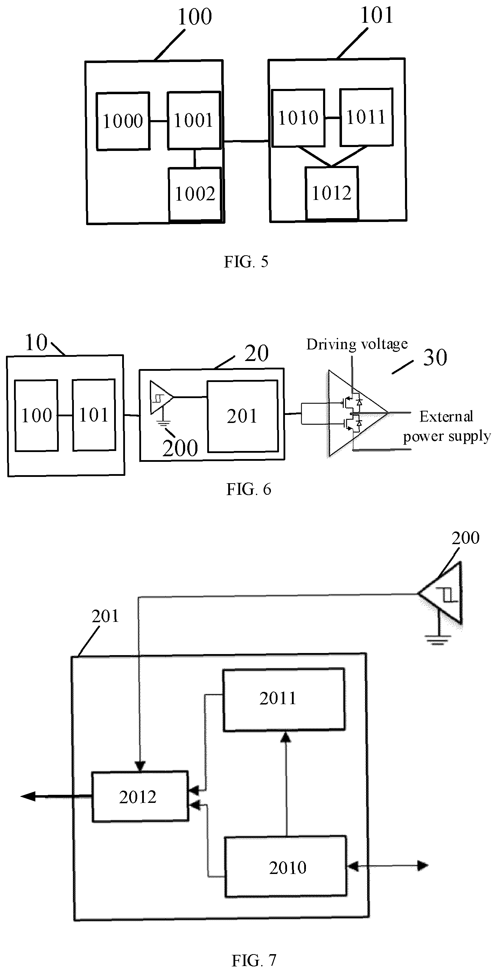

As shown in in FIG. 5, in the current detection circuit 1 provided in an embodiment of the present disclosure, the digital correction module 101 comprises a digital corrector 1010, a digital signal processor 1011, and a second compensation module 1012. The digital corrector 1010 is connected to the digital-to-analog conversion module 100 and configured to correct the digital signal corresponding to the target current to obtain a corrected digital signal. The digital signal processor 1011 is connected to the digital corrector 1010 and configured to perform averaging processing on the corrected digital signal to obtain the target current digital quantity. The second compensation module 1012 is connected to the digital corrector 1010 and the digital signal processor 1011, and configured to perform compensation processing when the digital corrector 1010 corrects the digital signal corresponding to the target current, so as to obtain the corrected digital signal, and configured to perform compensation processing when the digital signal processor 1011 performs averaging processing on the corrected digital signal, so as to obtain the target current digital quantity.

It should be noted that, in order to improve the accuracy of the current digital quantity, the second compensation module 1012 performs compensation processing when the digital corrector 1010 corrects the digital signal corresponding to the target current and when the digital signal processor 1011 performs averaging processing on the corrected digital signal. The the target current digital quantity can be obtained more accurately through the digital corrector 1010, the digital signal processor 1011, and the second compensation module 1012.

As shown in FIG. 6, in the current detection circuit 1 provided in an embodiment of the present disclosure, the logic processing module 20 comprises an electronic buffer 200 and a comparator module 201. The electronic buffer 200 is connected to the comparator module 201, and configured to receive a control signal to drive the comparator module 201 to work. The comparator module 201 is configured to output the target signal to the high-side driver module 30 based on the comparison detection result between the preset threshold and the target current digital quantity.

In an embodiment, after receiving a driving signal, the comparator module 201 outputs the target signal to the high-side driver module 30 based on the comparison detection result between the preset threshold and the target current digital quantity.

As shown in FIG. 7, in the current detection circuit 1 provided in an embodiment of the present disclosure, the comparator module 201 comprises a serial peripheral interface 2010, a register 2011 and a comparator 2012. The serial peripheral interface 2010 is configured to receive the target current digital quantity and write the target current digital quantity into the register 2011. The register 2011 is configured to store the target current digital quantity. The comparator 2012 is configured to output the target signal to the high-side driver module 30 based on the comparison detection result between the preset threshold and the target current digital quantity, that is, the comparator 2012 performs threshold judgment to output the target signal to the high-side driver module 30. For example, when the cell current value reaches a configured threshold, the high-side driver module 30 is triggered, the CMD logic control signal, to perform a shutdown action, so as to cut off the external power supply for protection.

It should be noted that, the high-side driver module 30 may be composed of field effect transistors, and the high-side driver module 30 cuts off the external power supply.

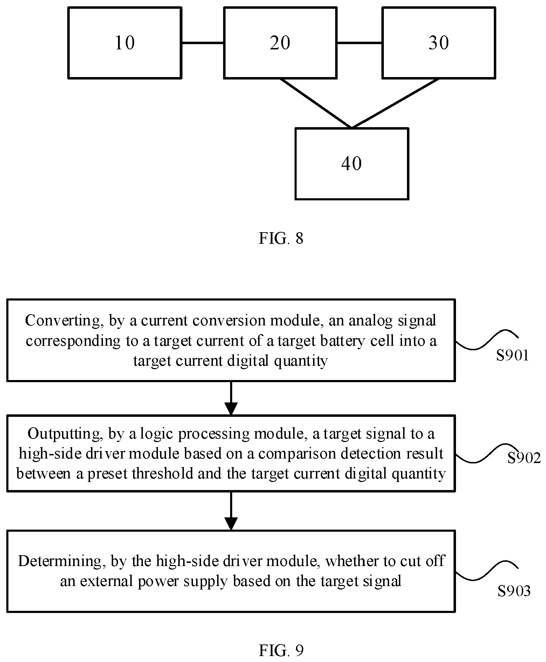

In an embodiment, in order to realize the above high-side driving function, a boost circuit needs to be provided in the current detection circuit 1 provided in the embodiment of the present disclosure, and therefore, as shown in FIG. 8, the current detection circuit 1 is further provided with a boost circuit 40. The boost circuit 40 is connected to the high-side driver module 30 and the logic processing module 20, respectively. The logic processing module 20 provides a clock signal to the boost circuit 40 to enable the boost circuit 40 to output a preset voltage value to the high-side driver module 30, so as to drive the high-side driver module 30 to work based on the preset voltage value. It should be noted that the boost circuit 40 may be a charging pump boost circuit. The high-side driver module 30 is driven by the boost circuit to perform a shutdown action, thereby cutting off external power supply for protection.

In an embodiment, the boost circuit 40 may be a direct current boost circuit. A working principle of the direct current boost circuit is to utilize characteristics of energy storage and energy release of an inductor and a capacitor to adjust an output voltage by controlling a switching frequency and a duty ratio of a switch element. When the switch element is turned on, the inductor stores energy; and when the switch element is turned off, the energy stored in the inductor is released to a load through a diode and the capacitor, thereby achieving voltage boosting. A controller adjusts the duty ratio of the switch element according to a feedback signal of the output voltage, so as to maintain a stable output voltage. The DC boost circuit can provide a stable driving voltage for the high-side driver module 30.

In an optional embodiment, a process of implementing a quantitative reliability analysis method for a current detection circuit is as follows:

(1) calculating an overall failure rate of a BMS integrated chip based on an IEC 62380 standard, and decomposing the overall failure rate to obtain failure rates of relevant modules of the current detection circuit, which is described in detail in table 1;

(2) analyzing the failure of the current detection circuits through DFMEA, and developing reliability and safety measures mechanisms, such as: SM_01 analog signal self-checking comparison, SM_02 CRC check of calibration parameter download, SM_03 independent CRC generator and detection circuit, SM_04 analog multi-path acquisition switch to digital-to-analog conversion decoding threshold value self-checking, SM_05 full-temperature redundant ADC circuit being capable of requesting conversion cross-checking fault injection, SM_06 fault injection self-checking, SM_07 full-redundant temperature ADC circuit conversion cross-checking, SM_08 charging pump voltage monitoring, SM_09 power supply over-voltage and under-voltage diagnosis, SM_10 analog self-checking, SM_11 drive comparison self-checking, and SM_12 background download calibration data CRC check, the relevant diagnostic coverage is specified with reference to ISO 26262, please see table 1 for details;

(3) performing quantitative FMEDA analysis on the current detection circuit with reference to ISO 26262 standard, and analyzing internal components of an integrated chip of the current detection circuit. The measurement mechanism (2) is used to diagnose the failure rate of the components in (1), so that the failure rate of the residual or single point failure is 0.242702 FIT, and the failure rate of potential multi-point failure is 0.17688826 FIT. The analysis process is shown in table 1.

**Table 1:**

| Component Name | Current conversion verification diagnosis | Logical processing | High-side drive | Charging pump | Power supply |
|---|---|---|---|---|---|
| Failure rate (FIT) | 2.0704 | 1.1984 | 2.84 | 2.3643 | 15.797 |
| Should reliability and safety related components be considered in calculations? | YES | YES | YES | YES | YES |
| Failure mode | Current conversion verification diagnosis failure | Logical processing failure | High-side drive failure | Charging pump failure | Power supply failure |
| Failure distribution (%) | 100 | 100 | 100 | 100 | 100 |
| Remaining reliability safety related failure rate (FIT) | 2.0704 | 1.1984 | 2.84 | 2.3643 | 15.7971 |
| Failure modes that violate safety objectives in the absence of reliable safety mechanisms? | YES | YES | YES | YES | YES |
| Safety mechanism to prevent failure modes from violating reliability and safety objectives? | SM_07, SM_05 | SM_02, SM_03, SM_12 | SM_01, SM_11 | SM_08 | SM_09 |
| Coverage rate of failure mode diagnosis in violation of reliability and safety objectives (%) | 99.0 | 99.0 | 99.0 | 99.0 | 99.0 |
| Failure rate (FIT) of residual or single point failure | 0.020704 | 0.011984 | 0.0284 | 0.023643 | 0.15797 1 |
| May failure modes that violate reliability and safety objectives be | YES | NO | NO | NO | YES |
| combined with independent failures of other components? | | | | | |
| Safety mechanism to prevent potential failure modes? | SM_04, SM_06 | - | - | - | SM_10 |
| Coverage rate of potential failure modes (%) | 99.0 | - | - | - | 99.0 |
| Potential multi-point failure rate (FIT) | 0.02049696 | - | - | - | 0.15639 13 |

In the current detection circuit provided in the embodiments of the present disclosure, the current conversion module is configured to convert an analog signal corresponding to a target current of a target battery cell into a target current digital quantity; the logic processing module is connected to the current conversion module and the high-side driver module, respectively, the logic processing module is configured to output a target signal to the high-side driver module based on a comparison detection result between a preset threshold value and the target current digital quantity; the high-side driver module is configured to determine whether to cut off an external power supply based on the target signal, thereby solving the problem in the related technologies that the reliability of cell current detection, diagnosis, and protection is poor due to the fact that the cell current detection, diagnosis, and protection are realized by different IC function circuits. In this solution, the current conversion module converts an analog signal corresponding to a current of a target battery cell into a target current digital quantity, then the logic processing module outputs a target signal to the high-side driver module based on a comparison detection result between a preset threshold value and the target current digital quantity, finally, the high-side driver module determines whether to cut off an external power supply based on the target signal. The current detection circuit realizes the cell current detection, diagnosis, and protection by an integration of the voltage conversion module, the logic processing module and the high-side driver module, thereby achieving the effect of improving the reliability of the cell current detection, diagnosis, and protection.

FIG. 9 is a flowchart of a current detection method according to the embodiments of the present disclosure. As shown in FIG. 9, the method includes:
step S901, converting, by a current conversion module, an analog signal corresponding to a target current of a target battery cell into a target current digital quantity;
step S902, outputting, by a logic processing module, a target signal to a high-side driver module based on a comparison detection result between a preset threshold and the target current digital quantity;
step S903, determining, by the high-side driver module, whether to cut off an external power supply based on the target signal.

The analog signal corresponding to the target current of the target battery cell is received through the current conversion module. It should be noted that, the current of the target battery cell can be collected by a current collection device, and then the collected current is input to a receiving pin PIN of the current conversion module. After receiving the analog signal corresponding to the target current of the target battery cell, the current conversion module performs discrete quantization filtering on the analog signal to extract a digital signal, and then converts the digital signal obtained into an accurate current digital quantity, so as to obtain the target current digital quantity.

After obtaining the target digital current quantity, the current conversion module can transmit the target digital current quantity to the logic processing module through a serial peripheral interface (SPI interface). The logic processing module outputs the target signal to the high-side driver module based on the comparison detection result between the preset threshold and the target digital current quantity, that is, the logic processing module performs threshold judgement, and triggers a response signal to the high-side driver module according to the threshold determination result. The high-side driver module 30 determines whether to cut off the external power supply according to the target signal. For example, when the cell current value reaches a configured threshold, the high-side driver module is triggered, by a CMD logic control signal, to perform a shutdown action, so as to cut off the external power supply of the battery for protection.

It should be noted that, the CMD logic control signal refers to a logic signal configured to control a switch state of the high-side driver. In an application of the high-side driver, these signals may be controlled through an SPI interface or other communication protocols.

In the present disclosure, the current conversion module converts an analog signal corresponding to a current of a target battery cell into a target current digital quantity, then the logic processing module outputs a target signal to the high-side driver module based on a comparison detection result between a preset threshold value and the target current digital quantity, finally, the high-side driver module determines whether to cut off an external power supply based on the target signal. The current detection circuit realizes the cell current detection, diagnosis and protection by an integration of the current conversion module, the logic processing module and the high-side driver module, thereby achieving the effect of improving the reliability of the cell current detection, diagnosis, and protection.

In an embodiment of the present disclosure, the current conversion module (10) comprises an analog-to-digital conversion module (100) and a digital correction module (101) connected to the analog-to-digital conversion module (100).

The step S901 specifically includes:
step A, converting, by the analog-to-digital conversion module (100), the analog signal corresponding to the target current of the target battery cell into a digital signal corresponding to the target current; and
step B, processing, by the digital correction module (101), the digital signal corresponding to the target current to obtain the target current digital quantity.

In an embodiment of the present disclosure, the current conversion module (10) further comprises an analog filter (102) connected to the analog-to-digital conversion module (100).

The step S901 further specifically includes:
step C, performing, by the analog filter (102), filtering processing on an initial analog signal corresponding to the target current, so as to obtain the analog signal corresponding to the target current.

In an embodiment of the present disclosure, the analog-to-digital conversion module (100) comprises a carrier suppression analog modulator (1000) and a digital filter (1001) connected to the carrier suppression analog modulator (1000).

The step A specifically includes:
step A1, modulating, by the carrier suppression analog modulator (1000), the analog signal corresponding to the target current to obtain a modulated signal; and
step A2, performing, by the digital filter (1001), filtering processing on the modulated signal to obtain the digital signal corresponding to the target current.

In an embodiment of the present disclosure, the analog-to-digital conversion module (100) further comprises a first compensation module (1002) connected to the digital filter (1001).

The step A further specifically includes:
step A3, performing, by the first compensation module (1002), compensation processing when the digital filter (1001) performs filtering processing on the modulated signal, so as to obtain the digital signal corresponding to the target current.

In an embodiment of the present disclosure, the digital correction module (101) comprises a digital corrector (1010), a digital signal processor (1011), and a second compensation module

(1012). The digital corrector (1010) is connected to the analog-to-digital conversion module (100). The digital signal processor (1011) is connected to the digital corrector (1010). The second compensation module (1012) connected to the digital corrector (1010) and the digital signal processor (1011), respectively.

The step B specifically includes:
step B1, correcting, by the digital corrector (1010), the digital signal corresponding to the target current to obtain a corrected digital signal;
step B2, performing, by the digital signal processor (1011), averaging processing on the corrected digital signal to obtain the target current digital quantity;
step B3, performing, by the second compensation module (1012), compensation processing when the digital corrector (1010) corrects the digital signal corresponding to the target current, so as to obtain the corrected digital signal; and performing, by the second compensation module (1012), compensation processing when the digital signal processor (1011) performs averaging processing on the corrected digital signal, so as to obtain the target current digital quantity.

In an embodiment of the present disclosure, the logic processing module (20) comprises an electronic buffer (200) and a comparator module (201).

The step S902 specifically includes:
step D, receiving, by the electronic buffer (200), a control signal to drive the comparator module (201) to work; and
step E, outputting, by the comparator module (201), the target signal to the high-side driver module (30) based on the comparison detection result between the preset threshold and the target digital current quantity.

In an embodiment of the present disclosure, the comparator module (201) comprises a serial peripheral interface (2010), a register (2011) and a comparator (2012).

The step E specifically includes:
step E1, receiving, by the serial peripheral interface (2010), the target current digital quantity and write the target current digital quantity into the register (2011);
step E2, storing, by the register (2011), the target current digital quantity; and
step E3, outputting, by the comparator (2012), the target signal to the high-side driver module (30) based on the comparison detection result between the preset threshold and the target current digital quantity.

In an embodiment of the present disclosure, the current detection method further comprises:
step F, providing, by the logic processing module (20), a clock signal to the boost circuit (40) to enable the boost circuit (40) to output a preset voltage value to the high-side driver module (30), so as to drive the high-side driver module (30) to work based on the preset voltage value.

The embodiments of the present disclosure provide a computer-readable storage medium, on which a program is stored. The program, when executed by a processor, causes the processor to implement the current detection method. The computer-readable storage medium may be non-volatile or volatile.

The embodiments of the present disclosure provide a processor. The processor is configured to run a program. The current detection method is executed when the program is run.

The embodiments of the present disclosure provide an electronic device. The device comprises a processor, a memory and a program stored in the memory and executable by the processor. When the processor executes the program, the current detection method is implemented.

## Claims

1. A current detection circuit (1), comprising:
a current conversion module (10) configured to convert an analog signal corresponding to a target current of a target battery cell into a target current digital quantity;
a logic processing module (20) connected to the current conversion module (10) and configured to output a target signal based on a comparison detection result between a preset threshold value and the target current digital quantity; and
a high-side driver module (30) connected to the logic processing module (20) and configured to determine whether to cut off an external power supply based on the target signal.

2. The current detection circuit (1) according to claim 1, wherein the current conversion module (10) comprises:
an analog-to-digital conversion module (100) configured to convert the analog signal corresponding to the target current of the target battery cell into a digital signal corresponding to the target current; and
a digital correction module (101) connected to the analog-to-digital conversion module (100) and configured to process the digital signal corresponding to the target current to obtain the target current digital quantity.

3. The current detection circuit (1) according to claim 2, wherein the current conversion module (10) further comprises:
an analog filter (102) connected to the analog-to-digital conversion module (100) and configured to perform filtering processing on an initial analog signal corresponding to the target current, so as to obtain the analog signal corresponding to the target current.

4. The current detection circuit (1) according to claim 2, wherein the analog-to-digital conversion module (100) comprises:
a carrier suppression analog modulator (1000) configured to modulate the analog signal corresponding to the target current to obtain a modulated signal; and
a digital filter (1001) connected to the carrier suppression analog modulator (1000) and configured to perform filtering processing on the modulated signal to obtain the digital signal corresponding to the target current.

5. The current detection circuit (1) according to claim 4, wherein the analog-to-digital conversion module (100) further comprises:
a first compensation module (1002) connected to the digital filter (1001), and configured to perform compensation processing when the digital filter (1001) performs filtering processing on the modulated signal, so as to obtain the digital signal corresponding to the target current.

6. The current detection circuit (1) according to claim 2, wherein the digital correction module (101) comprises:
a digital corrector (1010) connected to the analog-to-digital conversion module (100), and configured to correct the digital signal corresponding to the target current to obtain a corrected digital signal;
a digital signal processor (1011) connected to the digital corrector (1010) and configured to perform averaging processing on the corrected digital signal to obtain the target current digital quantity; and
a second compensation module (1012) connected to the digital corrector (1010) and the digital signal processor (1011), and configured to perform compensation processing when the digital corrector (1010) corrects the digital signal corresponding to the target current, so as to obtain the corrected digital signal; and configured to perform compensation processing when the digital signal processor (1011) performs averaging processing on the corrected digital signal, so as to obtain the target current digital quantity.

7. The current detection circuit (1) according to claim 1, wherein the logic processing module (20) comprises an electronic buffer (200) and a comparator module (201), wherein,
the electronic buffer (200) is configured to receive a control signal to drive the comparator module (201) to work; and
the comparator module (201) is configured to output the target signal to the high-side driver module (30) based on the comparison detection result between the preset threshold and the target digital current quantity.

8. The current detection circuit (1) according to claim 7, wherein the comparator module (201) comprises a serial peripheral interface (2010), a register (2011) and a comparator (2012), wherein,
the serial peripheral interface (2010) is configured to receive the target current digital quantity and write the target current digital quantity into the register (2011);
the register (2011) is configured to store the target current digital quantity; and
the comparator (2012) is configured to output the target signal to the high-side driver module (30) based on the comparison detection result between the preset threshold and the target current digital quantity.

9. The current detection circuit (1) according to any one of claims 1 to 8, wherein the current detection circuit (1) further comprises:
a boost circuit (40) connected to the high-side driver module (30) and the logic processing module (20), respectively; wherein the logic processing module (20) is configured to provide a clock signal to the boost circuit (40) to enable the boost circuit (40) to output a preset voltage value to the high-side driver module (30), so as to drive the high-side driver module (30) to work based on the preset voltage value.

10. The current detection circuit (1) according to claim 9, wherein the boost circuit (40) is a direct current boost circuit.

11. A current detection method, comprising:
converting, by a current conversion module, an analog signal corresponding to a target current of a target battery cell into a target current digital quantity;
outputting, by a logic processing module, a target signal to a high-side driver module based on a comparison detection result between a preset threshold and the target current digital quantity; and
determining, by the high-side driver module, whether to cut off an external power supply based on the target signal.

12. The current detection method according to claim 11, wherein the current conversion module (10) comprises an analog-to-digital conversion module (100) and a digital correction module (101) connected to the analog-to-digital conversion module (100);
wherein the converting, by a current conversion module, an analog signal corresponding to a target current of a target battery cell into a target current digital quantity comprises:
converting, by the analog-to-digital conversion module (100), the analog signal corresponding to the target current of the target battery cell into a digital signal corresponding to the target current; and
processing, by the digital correction module (101), the digital signal corresponding to the target current to obtain the target current digital quantity.

13. The current detection method according to claim 12, wherein the current conversion module (10) further comprises an analog filter (102) connected to the analog-to-digital conversion module (100);
wherein the converting, by a current conversion module, an analog signal corresponding to a target current of a target battery cell into a target current digital quantity further comprises:
performing, by the analog filter (102), filtering processing on an initial analog signal corresponding to the target current, so as to obtain the analog signal corresponding to the target current.

14. The current detection method according to claim 12, wherein the analog-to-digital conversion module (100) comprises a carrier suppression analog modulator (1000), a digital filter (1001), and a first compensation module (1002); wherein the digital filter (1001) is connected to the carrier suppression analog modulator (1000) and the first compensation module (1002), respectively;
wherein the converting, by the analog-to-digital conversion module (100), the analog signal corresponding to the target current of the target battery cell into a digital signal corresponding to the target current comprises:
modulating, by the carrier suppression analog modulator (1000), the analog signal corresponding to the target current to obtain a modulated signal;
performing, by the digital filter (1001), filtering processing on the modulated signal to obtain the digital signal corresponding to the target current; and
performing, by the first compensation module (1002), compensation processing when the digital filter (1001) performs filtering processing on the modulated signal, so as to obtain the digital signal corresponding to the target current.

15. The current detection method according to claim 12, wherein the digital correction module (101) comprises a digital corrector (1010), a digital signal processor (1011), and a second compensation module (1012); wherein the digital corrector (1010) is connected to the analog-to-digital conversion module (100); the digital signal processor (1011) is connected to the digital corrector (1010); the second compensation module (1012) connected to the digital corrector (1010) and the digital signal processor (1011), respectively;
wherein the processing, by the digital correction module (101), the digital signal corresponding to the target current to obtain the target current digital quantity comprises:
correcting, by the digital corrector (1010), the digital signal corresponding to the target current to obtain a corrected digital signal;
performing, by the digital signal processor (1011), averaging processing on the corrected digital signal to obtain the target current digital quantity;
performing, by the second compensation module (1012), compensation processing when the digital corrector (1010) corrects the digital signal corresponding to the target current, so as to obtain the corrected digital signal; and
performing, by the second compensation module (1012), compensation processing when the digital signal processor (1011) performs averaging processing on the corrected digital signal, so as to obtain the target current digital quantity.
